# FASCICULE DE BREVET EUROPEEN

(11) **EP 3 331 031 B1**
(45) Date de publication et mention de la délivrance du brevet: **29.07.2020**
(21) Numéro de dépôt: 17201495.3
(22) Date de dépôt: 14.11.2017
(51) Int. Cl.: H01L 31/0216, H01L 31/068, H01L 31/18

(54) **PROCEDE DE FABRICATION D'UNE CELLULE PHOTOVOLTAIQUE ET CELLULE PHOTOVOLTAIQUE**
VERFAHREN ZUR HERSTELLUNG EINER FOTOVOLTAIKZELLE UND FOTOVOLTAIKZELLE
METHOD FOR MANUFACTURING A PHOTOVOLTAIC CELL AND PHOTOVOLTAIC CELL

(30) Priorité: 30.11.2016 FR 1661732
(43) Date de publication de la demande: 06.06.2018
(73) Titulaire: Commissariat à l'Energie Atomique et aux Energies Alternatives, 75015 Paris (FR)
(72) Inventeur: CABAL, Raphaël, 73000 CHAMBERY (FR); GRANGE, Bernadette, 73000 CHAMBERY (FR)
(74) Mandataire: GIE Innovation Competence Group

(56) Documents cités:
- CABAL R., GRANGE B., MONNA R., VESCHETTI Y., DUBOIS S.: "20% N-PERT SOLAR DEVICE IN ONLY 7 STEPS: THE SOLENNA(3) CONCEPT", 32TH EUROPEAN PHOTOVOLTAIC SOLAR ENERGY CONFERENCE, PROCEEDINGS OF THE 32TH INTERNATIONAL CONFERENCE, WIP-RENEWABLE ENERGIES, SYLVENSTEINSTR. 2 81369 MUNICH, GERMANY, 22 juillet 2016 (2016-07-22), XP040679854, ISBN: 978-3-936338-41-6
- PHILIP ROTHHARDT ET AL: "Codiffused Bifacial n-type Solar Cells (CoBiN)", ENERGY PROCEDIA, vol. 55, 1 janvier 2014 (2014-01-01), pages 287-294, XP055391140, NL ISSN: 1876-6102, DOI: 10.1016/j.egypro.2014.08.084
- CABAL RAPHAËL ET AL: "Multifunctional Dielectric Layers for the Fabrication of Ultra-Simplified n-PERT c-Si Solar Cells", ENERGY PROCEDIA, ELSEVIER, NL, vol. 92, 23 septembre 2016 (2016-09-23), pages 684-690, XP029715885, ISSN: 1876-6102, DOI: 10.1016/J.EGYPRO.2016.07.044

## Description

### Domaine technique

L'invention se rapporte au domaine technique des cellules photovoltaïques.

L'invention trouve notamment son application dans la fabrication de cellules photovoltaïques de type PERT (*Passivated Emitter Rear Totally-diffused* en langue anglaise).

### Etat de la technique antérieure

Un procédé connu de l'état de la technique, notamment du document « Codiffused bifacial n-type Solar Cells (CoBiN) », P. Rothhardt et al., Energy Procedia, vol. 55, 2014, 287-294, comporte les étapes :
a₀) prévoir un substrat semi-conducteur réalisé dans un matériau à base de silicium cristallin dopé de type n, le substrat comportant une première surface et une seconde surface opposée,
b₀) former une première couche diélectrique à la première surface du substrat, la première couche diélectrique comportant des atomes de bore, le substrat et la première couche diélectrique formant une structure,
c₀) appliquer un recuit thermique à la structure sous une atmosphère contenant du POCl₃ adapté pour :
   - diffuser les atomes de bore depuis la première couche diélectrique sous la première surface du substrat de manière à former une première zone semi-conductrice, la première zone semi-conductrice formée par les atomes de bore diffusés étant destinée à être en contact avec une électrode,
   - diffuser les atomes de phosphore issus du POCl₃ sous la seconde surface du substrat de manière à former une deuxième zone semi-conductrice, la deuxième zone semi-conductrice formée par les atomes de phosphore diffusés étant destinée à être en contact avec une électrode.

La première couche diélectrique formée lors de l'étape b₀) comporte une première sous-couche réalisée dans un matériau à base d'un oxyde de silicium SiOₓ et une deuxième sous-couche réalisée dans un matériau à base d'un verre borosilicate (BSG). La première couche diélectrique est formée par un dépôt chimique en phase vapeur à pression atmosphérique.

L'exécution de l'étape c₀) s'accompagne de la formation d'une couche d'un verre phosphosilicate (PSG) à la seconde surface du substrat.

Puis le BSG et le PSG sont retirés par gravure après l'étape c₀) avec une solution à base d'acide fluorhydrique. Ainsi, après la gravure du BSG et du PSG et le nettoyage des première et seconde surfaces du substrat, une première et une deuxième couches de passivation sont formées respectivement à la première et à la seconde surfaces du substrat. La première couche de passivation comporte une première sous-couche d'alumine et une deuxième sous-couche de nitrure de silicium SiNₓ. La deuxième couche de passivation comporte une première sous-couche d'oxynitrure de silicium SiOₓN_{y} et une deuxième sous-couche de nitrure de silicium SiNₓ.

Un tel procédé de l'état de la technique n'est pas entièrement satisfaisant dans la mesure où il comporte un nombre important d'étapes à exécuter. En particulier, la formation puis la suppression du BSG et du PSG introduisent une complexité et un temps d'opération non négligeable dans la mise en œuvre de ce procédé.

Le document « 20% N-Pert Solar Device in only 7 Steps, The SOLENNA (3) Concept » R. Cabal et al. 32th European photovoltaic solar energy conference, Proceedings of the 32th international conference, WIP-RENEWABLE ENERGIES, Sylvensteinstr. 2 81369 MUNICH 2016-07-22 décrit une architecture avec un substrat en silicium dont une première face est recouverte par un oxynitrure de silicium ayant des atomes de bore et dont la deuxième face est recouverte par une couche diélectrique ayant des atomes de phosphore. Un traitement thermique est appliqué et fait diffuser les atomes de bore et de phosphore.

### Exposé de l'invention

L'invention vise à remédier en tout ou partie aux inconvénients précités. A cet effet, l'invention a pour objet un procédé de fabrication d'une cellule photovoltaïque, comportant les étapes :
a) prévoir une structure comprenant :
   - un substrat à base de silicium cristallin, présentant une première surface et une seconde surface opposée ;
   - une couche à base d'alumine, formée à la première surface du substrat, et présentant une épaisseur strictement inférieure à 20 nm ;
   - une première couche diélectrique, à base d'un oxynitrure de silicium SiOₓN_{y} vérifiant 0≤y<x, comprenant des atomes de bore, et formée sur la couche à base d'alumine ;
   - une seconde couche diélectrique, comprenant des atomes de phosphore ou d'arsenic, formée à la seconde surface du substrat ;
b) appliquer un traitement thermique à la structure de manière à :
   - diffuser les atomes de bore depuis la première couche diélectrique sous la première surface du substrat, de manière à former une première région semi-conductrice dopée destinée à être en contact avec une électrode ;
   - diffuser les atomes de phosphore ou d'arsenic depuis la seconde couche diélectrique sous la seconde surface du substrat, de manière à former une seconde région semi-conductrice dopée destinée à être à contact avec une électrode.

Ainsi, un tel procédé selon l'invention permet d'utiliser les excellentes propriétés de passivation de l'alumine tout en s'affranchissant de ses problèmes de stabilité thermique grâce à la première couche diélectrique, à base d'un oxynitrure de silicium, recouvrant la première couche à base d'alumine. La première couche présente une épaisseur strictement inférieure à 20 nm afin de ne pas former une barrière de diffusion pour les atomes de bore lors de l'étape b) qui est exécutée à haute température (supérieure à 850°C).

Contrairement à l'état de la technique, il est ainsi rendu possible de conserver la première couche diélectrique après l'étape b), c'est-à-dire qu'il n'est plus nécessaire de graver la première couche diélectrique après l'étape b) puis de déposer une couche de passivation dédiée. Le procédé est donc simplifié et le temps d'opération est réduit. En outre, la co-diffusion des atomes de bore et de phosphore ou d'arsenic lors de l'étape b) permet également de réduire le nombre d'étapes à exécuter.

### Définitions

- Par « substrat », on entend le support mécanique, autoporté, destiné à la fabrication d'une cellule photovoltaïque.
- Par « passiver/passivation », on entend la neutralisation de défauts électriquement actifs à la surface du substrat. En effet, la surface d'un substrat à base de silicium cristallin présente une densité de défauts (e.g. liaisons pendantes, impuretés, discontinuité du cristal etc.) pouvant entraîner des pertes non négligeables liées à la recombinaison en surface des porteurs dans le cas d'une application photovoltaïque.
- Par « cristallin », on entend la forme multicristalline ou la forme monocristalline du silicium, excluant donc le silicium amorphe.
- Par « à base de », on entend que le matériau correspondant est le matériau principal et majoritaire composant le substrat (ou la couche).
- Par « alumine », on entend l'oxyde d'aluminium de formule Al₂O₃ ou ses dérivés AlOₓ non stœchiométriques.
- Par « diélectrique », on entend que la couche présente une conductivité électrique à 300 K inférieure à 10⁻⁸ S/cm.

Le procédé selon l'invention peut comporter une ou plusieurs des caractéristiques suivantes.

Selon une caractéristique de l'invention, la couche à base d'alumine présente une épaisseur comprise entre 2 nm et 10 nm.

Ainsi, une telle gamme d'épaisseur donne les meilleurs résultats en termes de sur-dopage du silicium en bore, se manifestant par une faible résistance électrique à la première surface du substrat.

Selon une caractéristique de l'invention, le procédé comporte une étape c) consistant à former une couche à base d'un oxynitrure de silicium SiOₓN_{y} vérifiant 0≤x<y, de préférence hydrogéné, sur la première couche diélectrique après l'étape b).

Ainsi, un avantage procuré est d'améliorer la passivation de la première surface et de former une couche optique dite antireflet. L'étape c) est exécutée après l'étape b) afin d'enrichir aisément en oxygène la première couche diélectrique lorsque l'étape b) est exécutée sous une atmosphère oxydante.

Selon une caractéristique de l'invention, la première couche diélectrique présente une épaisseur comprise entre 3 nm et 50 nm, de préférence comprise entre 20 nm et 35 nm.

Ainsi, un avantage procuré est d'allier une bonne qualité de passivation de la première surface et une faible consommation de matière.

Selon une caractéristique de l'invention, les atomes de bore présentent une proportion atomique dans la première couche diélectrique comprise entre 10% et 50%, de préférence comprise entre 10% et 30%, avant l'étape b).

Ainsi, de telles proportions atomiques permettent à la fois de :
- former une première région semi-conductrice dopée de bonne qualité, c'est-à-dire avec une concentration atomique surfacique supérieure à 10¹⁹ at.cm⁻³,
- conserver une bonne qualité de passivation de la première surface, une proportion atomique trop élevée de bore affectant les propriétés de passivation.

Selon une caractéristique de l'invention, l'oxynitrure de silicium de la première couche diélectrique vérifie 0,2≤x≤0,5 et 0,05≤y≤0,15 avant l'étape b).

Ainsi, un avantage procuré est d'obtenir d'excellentes propriétés de passivation.

Selon une caractéristique de l'invention, la seconde couche diélectrique est à base d'un oxynitrure de silicium SiOₓN_{y} vérifiant 0≤x<y, de préférence hydrogéné.

Selon une caractéristique de l'invention, l'oxynitrure de silicium de la seconde couche diélectrique vérifie 0≤x<0,05 et 0,30≤y≤0,55 avant et après l'étape b).

Ainsi, un avantage procuré est d'améliorer les propriétés de passivation relativement à une couche d'oxyde thermique SiO₂.

Selon une caractéristique de l'invention, les atomes de phosphore ou d'arsenic présentent une proportion massique dans la seconde couche diélectrique supérieure ou égale à 4%, de préférence comprise entre 10% et 30%.

Ainsi, de telles proportions massiques de phosphore ou d'arsenic permettent à la fois de :
- former une seconde région semi-conductrice dopée de bonne qualité, c'est-à-dire avec une concentration atomique surfacique supérieure à 10²⁰ at.cm⁻³,
- conserver une bonne qualité de passivation de la seconde surface, une proportion massique trop élevée de phosphore ou d'arsenic affectant les propriétés de passivation.

Selon une caractéristique de l'invention, la seconde couche diélectrique présente une épaisseur comprise entre 10 nm et 50 nm, de préférence comprise entre 10 nm et 30 nm.

Ainsi, un avantage procuré est d'allier une bonne qualité de passivation de la seconde surface, et une faible consommation de matière.

Selon une caractéristique de l'invention, l'étape b) est exécutée en appliquant un recuit thermique sous une atmosphère oxydante, le recuit thermique présentant :
- une valeur de température de recuit comprise entre 850°C et 950°C, de préférence comprise entre 900°C et 950°C,
- une valeur de durée de recuit comprise entre 10 minutes et 1 heure, de préférence comprise entre 30 minutes et 1 heure.

Par « recuit thermique », on entend un traitement thermique comportant :
- une phase de montée graduelle en température (rampe de montée) jusqu'à atteindre une température dite température de recuit,
- une phase de maintien (plateau) à la température de recuit, pendant une durée dite durée de recuit,
- une phase de refroidissement.

Ainsi, un avantage procuré par l'atmosphère oxydante est d'améliorer les propriétés de passivation de la première surface en enrichissant en oxygène la première couche diélectrique.

Selon une caractéristique de l'invention, les première et deuxième couches diélectriques sont conservées après l'étape b).

Ainsi, un avantage procuré est un gain de temps d'opération puisqu'il n'est pas nécessaire de retirer ces couches puis de former des couches de passivation dédiées.

Selon une caractéristique de l'invention, la structure prévue lors de l'étape a) comporte une couche additionnelle à base d'un oxynitrure de silicium SiOₓN_{y} vérifiant 0≤x<y avec x≥0,05, de préférence hydrogéné, formée sur la seconde couche diélectrique.

Ainsi, une telle couche additionnelle permet à la fois d'améliorer la passivation de la seconde surface et de former une couche optique dite antireflet, de par une épaisseur adaptée.

Selon une caractéristique de l'invention, la couche additionnelle présente une épaisseur inférieure ou égale à 80 nm.

Selon une caractéristique de l'invention, le substrat de la structure prévue lors de l'étape a) est dopé de type n ou p ; et la première surface ou la seconde surface du substrat est destinée à être exposée à un rayonnement lumineux.

Ainsi, selon un premier mode de mise en œuvre, le substrat prévu lors de l'étape a) est dopé de type n et la première surface du substrat est destinée à être exposée à un rayonnement lumineux de manière à former une architecture à émetteur standard.

Selon un deuxième mode de mise en œuvre, le substrat prévu lors de l'étape a) est dopé de type n et la seconde surface du substrat est destinée à être exposée à un rayonnement lumineux de manière à former une architecture à émetteur inversé.

Selon un troisième mode de mise en œuvre, le substrat prévu lors de l'étape a) est dopé de type p et la première surface du substrat est destinée à être exposée à un rayonnement lumineux de manière à former une architecture à émetteur inversé.

Selon un quatrième mode de mise en œuvre, le substrat prévu lors de l'étape a) est dopé de type p et la seconde surface du substrat est destinée à être exposée à un rayonnement lumineux de manière à former une architecture à émetteur standard.

L'invention a également pour objet une cellule photovoltaïque, comportant :
- un substrat à base de silicium cristallin, présentant une première surface et une seconde surface opposée ;
- des première et seconde régions semi-conductrices dopées s'étendant respectivement sous la première surface et sous la seconde surface du substrat, la première région semi-conductrice dopée comprenant des atomes de bore, la seconde région semi-conductrice dopée comprenant des atomes de phosphore ou d'arsenic ;
- une couche à base d'alumine, formée à la première surface du substrat, présentant une épaisseur strictement inférieure à 20 nm, et comprenant des atomes de bore dans une proportion résiduelle ;
- une première couche diélectrique, à base d'un oxynitrure de silicium SiOₓN_{y} vérifiant 0≤y<x, comprenant des atomes de bore dans une proportion résiduelle, et formée sur la couche à base d'alumine ;
- une seconde couche diélectrique, comprenant des atomes de phosphore ou d'arsenic dans une proportion résiduelle, formée à la seconde surface du substrat.

Ainsi, une telle cellule photovoltaïque se distingue de l'état de la technique notamment par :
- une couche à base d'alumine comprenant des atomes de bore dans une proportion résiduelle (notée AlOₓ : B) avec une quantité suffisante pour être détectée par ingénierie inverse,
- une première couche diélectrique comportant des atomes de bore dans une proportion résiduelle qui n'ont pas diffusé sous la première surface, et avec une quantité suffisante pour être détectée par ingénierie inverse.

La cellule photovoltaïque selon l'invention peut comporter une ou plusieurs des caractéristiques suivantes.

Selon une caractéristique de l'invention, la couche à base d'alumine présente une épaisseur comprise entre 2 nm et 10 nm.

Ainsi, une telle gamme d'épaisseur donne les meilleurs résultats en termes de sur-dopage du silicium en bore, se manifestant par une faible résistance électrique à la première surface du substrat.

Selon une caractéristique de l'invention, la cellule photovoltaïque comporte une couche à base d'un oxynitrure de silicium SiOₓN_{y} vérifiant 0≤x<y, de préférence hydrogéné, formée sur la première couche diélectrique.

Ainsi, un avantage procuré est d'améliorer la passivation de la première surface du substrat, et d'empêcher l'exo-diffusion des atomes de bore.

Selon une caractéristique de l'invention, la première couche diélectrique présente une épaisseur comprise entre 3 nm et 50 nm, de préférence comprise entre 20 nm et 35 nm.

Ainsi, un avantage procuré est d'allier une bonne qualité de passivation de la première surface et une faible consommation de matière.

Selon une caractéristique de l'invention, la seconde couche diélectrique est à base d'un oxynitrure de silicium SiOₓN_{y} vérifiant 0≤x<y, de préférence hydrogéné, et vérifiant plus préférentiellement 0≤x<0,05 et 0,30≤y≤0,55.

Ainsi, un avantage procuré est d'améliorer les propriétés de passivation relativement à une couche d'oxyde thermique SiO₂.

Selon une caractéristique de l'invention, la seconde couche diélectrique présente une épaisseur comprise entre 10 nm et 50 nm, de préférence comprise entre 10 nm et 30 nm.

Ainsi, un avantage procuré est d'allier une bonne qualité de passivation de la seconde surface, et une faible consommation de matière.

Selon une caractéristique de l'invention, la cellule photovoltaïque comporte une couche additionnelle à base d'un oxynitrure de silicium SiOₓN_{y} vérifiant 0≤x<y avec x≥0,05, de préférence hydrogéné, formée sur la seconde couche diélectrique.

Ainsi, une telle couche additionnelle permet à la fois d'améliorer la passivation de la seconde surface, de former une couche optique dite antireflet, de par une épaisseur adaptée, et d'empêcher l'exo-diffusion des atomes de phosphore ou d'arsenic hors de la seconde couche diélectrique.

Selon une caractéristique de l'invention, la couche additionnelle présente une épaisseur inférieure ou égale à 80 nm.

Selon une caractéristique de l'invention, le substrat est dopé de type n ou p ; et la première surface ou la seconde surface du substrat est destinée à être exposée à un rayonnement lumineux.

Ainsi, selon un premier mode de réalisation, le substrat est dopé de type n et la première surface du substrat est destinée à être exposée à un rayonnement lumineux de manière à former une architecture à émetteur standard.

Selon un deuxième mode de réalisation, le substrat prévu est dopé de type n et la seconde surface du substrat est destinée à être exposée à un rayonnement lumineux de manière à former une architecture à émetteur inversé.

Selon un troisième mode de réalisation, le substrat est dopé de type p et la première surface du substrat est destinée à être exposée à un rayonnement lumineux de manière à former une architecture à émetteur inversé.

Selon un quatrième mode de réalisation, le substrat est dopé de type p et la seconde surface du substrat est destinée à être exposée à un rayonnement lumineux de manière à former une architecture à émetteur standard.

### Brève description des dessins

D'autres caractéristiques et avantages apparaîtront dans l'exposé détaillé de différents modes de réalisation de l'invention, l'exposé étant assorti d'exemples et de référence aux dessins joints.
Figures la à 1g sont des vues schématiques en coupe illustrant différentes étapes d'un procédé selon l'invention.

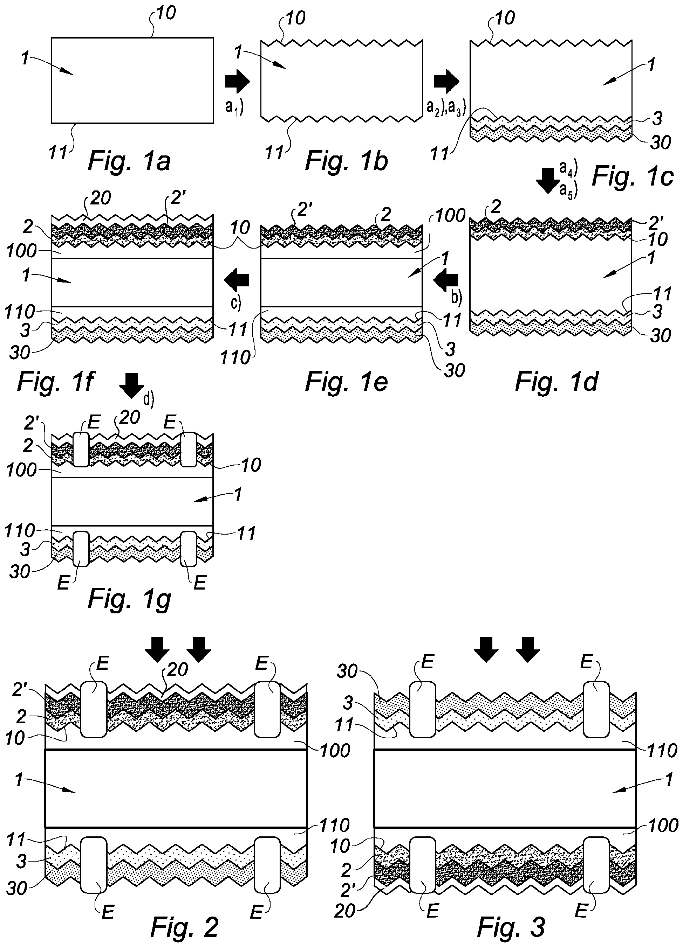

Figures 2 à 5 sont des vues schématiques en coupe de cellules photovoltaïques selon l'invention, les flèches indiquant la face de la cellule destinée à être exposée à un rayonnement solaire.

### Exposé détaillé des modes de réalisation

Les éléments identiques ou assurant la même fonction porteront les mêmes références pour les différents modes de réalisation, par souci de simplification.

Comme illustré aux figures la à 1g, un objet de l'invention est un procédé de fabrication d'une cellule photovoltaïque, comportant les étapes :
a) prévoir une structure comprenant :
   - un substrat 1 à base de silicium cristallin, présentant une première surface 10 et une seconde surface 11 opposée ;
   - une couche à base d'alumine 2, formée à la première surface 10 du substrat 1, et présentant une épaisseur strictement inférieure à 20 nm ;
   - une première couche diélectrique 2', à base d'un oxynitrure de silicium SiOₓN_{y} vérifiant 0≤y<x, comprenant des atomes de bore, et formée sur la couche à base d'alumine 2 ;
   - une seconde couche diélectrique 3, comprenant des atomes de phosphore ou d'arsenic, formée à la seconde surface 11 du substrat 1 ;
b) appliquer un traitement thermique à la structure de manière à :
   - diffuser les atomes de bore depuis la première couche diélectrique 2' sous la première surface 10 du substrat 1, de manière à former une première région semi-conductrice dopée 100 destinée à être en contact avec une électrode E ;
   - diffuser les atomes de phosphore ou d'arsenic depuis la seconde couche diélectrique 3 sous la seconde surface 11 du substrat 1, de manière à former une seconde région semi-conductrice dopée 110 destinée à être à contact avec une électrode E.

### Substrat

Le substrat 1 de la structure prévue lors de l'étape a) est dopé de type n ou p. La première surface 10 ou la seconde surface 11 du substrat 1 est destinée à être exposée à un rayonnement lumineux.

Selon un premier mode de réalisation illustré à la figure 2, le substrat 1 est dopé de type n et la première surface 10 du substrat 1 est destinée à être exposée à un rayonnement lumineux (symbolisé par une double flèche à la figure 2) de manière à former une architecture de type n à émetteur standard. La première région semi-conductrice dopée 100 forme l'émetteur tandis que la seconde région semi-conductrice dopée 110, du même type de dopage que le substrat 1, est de type BSF (acronyme pour «*Back Surface Field*» en langue anglaise).

Selon un deuxième mode de réalisation illustré à la figure 3, le substrat 1 est dopé de type n et la seconde surface 11 du substrat 1 est destinée à être exposée à un rayonnement lumineux (symbolisé par une double flèche à la figure 3) de manière à former une architecture de type n à émetteur inversé. La première région semi-conductrice dopée 100 forme l'émetteur. La seconde région semi-conductrice dopée 110, du même type de dopage que le substrat 1, est de type FSF (acronyme pour « *Front Surface Field*» en langue anglaise).

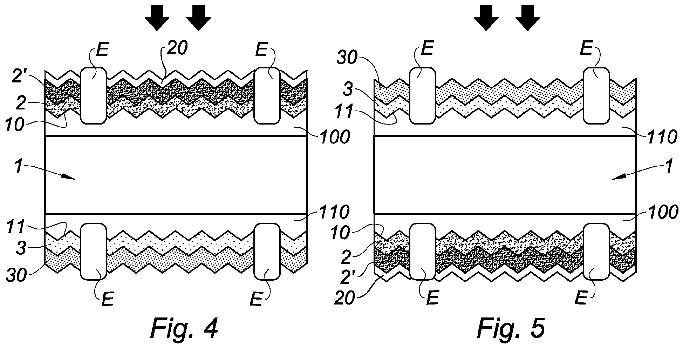

Selon un troisième mode de réalisation illustré à la figure 4, le substrat 1 est dopé de type p et la première surface 10 du substrat 1 est destinée à être exposée à un rayonnement lumineux (symbolisé par une double flèche à la figure 2) de manière à former une architecture de type p à émetteur inversé. La seconde région semi-conductrice dopée 110 forme l'émetteur. La première région semi-conductrice dopée 100, du même type de dopage que le substrat 1, est de type FSF (acronyme pour « *Front Surface Field*» en langue anglaise).

Selon un quatrième mode de réalisation illustré à la figure 5, le substrat 1 est dopé de type p et la seconde surface 11 du substrat 1 est destinée à être exposée à un rayonnement lumineux (symbolisé par une double flèche à la figure 3) de manière à former une architecture de type p à émetteur standard. La seconde région semi-conductrice dopée 110 forme l'émetteur tandis que la première région semi-conductrice dopée 100, du même type de dopage que le substrat 1, est de type BSF (acronyme pour «*Back Surface Field*» en langue anglaise).

Ces champs de surface avant et arrière (FSF et BSF) permettent de réduire les recombinaisons des porteurs de charge à la surface 10, 11 correspondante du substrat 1.

Le matériau semi-conducteur dans lequel est réalisé le substrat 1 est à base de silicium cristallin, préférentiellement monocristallin.

Comme illustré à la figure 1b, l'étape a) comporte avantageusement une étape a₁) consistant à former des motifs de texturation aux première et seconde surfaces 10, 11 du substrat 1, et ce afin de réduire le coefficient de réflexion et les pertes optiques dans la cellule photovoltaïque. Ainsi, les première et seconde surfaces 10, 11 du substrat 1 comportent préférentiellement des motifs en pyramide inversée agencés pour créer une rugosité de surface. La texturation est préférentiellement exécutée par une attaque chimique à base d'hydroxyde de potassium KOH. A titre d'exemple non limitatif, le substrat 1 présente une épaisseur de l'ordre de 150 µm. Le procédé comporte avantageusement une étape consistant à nettoyer chimiquement les première et seconde surfaces 10, 11 du substrat 1 avant la formation de la couche à base d'alumine 2 et de la seconde couche diélectrique 3.

### Couche à base d'alumine

La couche à base d'alumine 2 de la structure prévue lors de l'étape a) présente avantageusement une épaisseur comprise entre 2 nm et 10 nm. Comme illustré à la figure 1d, l'étape a) comporte avantageusement une étape a₄) consistant à déposer la couche à base d'alumine 2 sur la première surface 10 du substrat 1, de préférence par ALD (Pour «A*tomic Layer Deposition*» en langue anglaise). La couche d'alumine 2 peut être déposée par ALD thermique ou plasma. La couche d'alumine 2 peut également être déposée par PECVD.

La couche à base d'alumine 2 est conservée après l'étape b).

### Première couche diélectrique

Lorsque y=0, l'oxynitrure de silicium est un oxyde de silicium. Comme illustré à la figure 1d, l'étape a) comporte avantageusement une étape a₅) consistant à former la première couche diélectrique 2' sur la couche à base d'alumine 2. La première couche diélectrique 2' présente avantageusement une épaisseur comprise entre 3 nm et 50 nm, de préférence comprise entre 20 nm et 35 nm. Les atomes de bore présentent avantageusement une proportion atomique dans la première couche diélectrique comprise entre 10% et 50%, de préférence comprise entre 10% et 30%, avant l'étape b). L'oxynitrure de silicium de la première couche diélectrique 2' vérifie avantageusement 0,2≤x≤0,5 et 0,05≤y≤0,15 avant l'étape b). La première couche diélectrique 2' est conservée après l'étape b).

Le procédé comporte avantageusement une étape c) consistant à former une couche 20 à base d'un oxynitrure de silicium SiOₓN_{y} vérifiant 0≤x<y, de préférence hydrogéné, sur la première couche diélectrique 2' après l'étape b).

Lorsque la première couche diélectrique 2' et la couche 20 sont réalisées dans un matériau à base d'un oxynitrure de silicium hydrogéné, les étapes a₅) et c) sont avantageusement exécutées par un dépôt chimique en phase vapeur (PECVD pour *Plasma-Enhanced Chemical Vapor Deposition* en langue anglaise) à partir de gaz réactifs comportant du silane SiH₄ et du protoxyde d'azote N₂O ou du NH₃. Les atomes de bore sont avantageusement incorporés à l'oxynitrure de silicium hydrogéné par une injection de diborane B₂H₆ avec les gaz réactifs.

### Seconde couche diélectrique

La seconde couche diélectrique 3 est avantageusement à base d'un oxynitrure de silicium SiOₓN_{y} vérifiant 0≤x<y, de préférence hydrogéné. Lorsque x=0, l'oxynitrure de silicium est un nitrure de silicium. Comme illustré à la figure 1c, l'étape a) comporte avantageusement une étape a₂) consistant à former la seconde couche diélectrique 3 sur le seconde surface 11 du substrat 1. L'oxynitrure de silicium de la seconde couche diélectrique 3 vérifie avantageusement 0≤x<0,05 et 0,30≤y≤0,55 avant et après l'étape b). Les atomes de phosphore ou d'arsenic présentent avantageusement une proportion massique dans la seconde couche diélectrique 3 supérieure ou égale à 4%, de préférence comprise entre 10% et 30%. La seconde couche diélectrique 3 présente avantageusement une épaisseur comprise entre 10 nm et 50 nm, de préférence comprise entre 10 nm et 30 nm.

La structure prévue lors de l'étape a) comporte avantageusement une couche additionnelle 30 à base d'un oxynitrure de silicium SiOₓN_{y} vérifiant 0≤x<y avec x≥0,05, de préférence hydrogéné, formée sur la seconde couche diélectrique 3. La couche additionnelle 30 présente avantageusement une épaisseur inférieure ou égale à 80 nm. Comme illustré à la figure 1c, le procédé comporte avantageusement une étape a₃) consistant à former la couche additionnelle 30 sur la seconde couche diélectrique 3.

Lorsque la seconde couche diélectrique 3 et la couche additionnelle 30 sont réalisées dans un matériau à base d'un oxynitrure de silicium hydrogéné, les étapes a₂) et a₃) sont avantageusement exécutées par un dépôt chimique en phase vapeur (PECVD pour *Plasma-Enhanced Chemical Vapor Déposition* en langue anglaise) à partir de gaz réactifs comportant du silane SiH4 et du NH₃. Lorsque la deuxième couche diélectrique 3 comporte des atomes de phosphore, lesdits atomes sont avantageusement incorporés à l'oxynitrure de silicium hydrogéné par une injection de phosphine PH₃ avec les gaz réactifs. Lorsque la deuxième couche diélectrique 3 comporte des atomes d'arsenic, lesdits atomes sont avantageusement incorporés à l'oxynitrure de silicium hydrogéné par une injection d'arsine AsH₃ avec les gaz réactifs.

La seconde couche diélectrique 3 et la couche additionnelle 30 sont conservées après l'étape d).

Les étapes a₄) et a₅) peuvent être interverties avec les étapes a₂) et a₃). Autrement dit, les étapes a₄) et a₅) peuvent être exécutées avant les étapes a₂) et a₃). En revanche, l'étape c) est avantageusement exécutée après l'étape b) afin d'enrichir aisément en oxygène la première couche diélectrique 2' lorsque l'étape b) est exécutée sous une atmosphère oxydante.

### Traitement thermique appliqué lors de l'étape b)

L'étape b) est avantageusement exécutée en appliquant un recuit thermique sous une atmosphère oxydante, le recuit thermique présentant :
- une valeur de température de recuit comprise entre 850°C et 950°C, de préférence comprise entre 900°C et 950°C,
- une valeur de durée de recuit comprise entre 10 minutes et 1 heure, de préférence comprise entre 30 minutes et 1 heure.

Le recuit thermique est avantageusement appliqué lors de l'étape b) sous une pression atmosphérique. Le recuit thermique appliqué lors de l'étape b) est un recuit thermique global au sens où il est appliqué à l'ensemble de la structure prévue lors de l'étape a). Il ne s'agit donc pas d'un recuit thermique localisé appliqué sur une partie dudit ensemble, par exemple à l'aide d'un laser. L'étape b) est préférentiellement exécutée dans un four.

L'atmosphère oxydante comporte avantageusement un mélange de dioxygène et d'un gaz neutre choisi parmi l'argon, l'azote, ou un mélange d'argon et d'azote. L'atmosphère oxydante est avantageusement constituée par un mélange de dioxygène et d'un gaz neutre choisi parmi l'argon, l'azote, ou un mélange d'argon et d'azote. L'atmosphère oxydante est avantageusement dépourvue d'agent dopant telle que la phosphine.

Après l'étape b), la première région semi-conductrice dopée 100 présente préférentiellement, à la première surface 10 du substrat 1, une concentration atomique surfacique en bore supérieure à 10¹⁹ at./cm³, plus préférentiellement comprise entre 10¹⁹ at./cm³ et 3x10²⁰ at./cm³, afin de former une zone de contact électrique de bonne qualité.

Après l'étape b), la seconde région semi-conductrice dopée 110 présente préférentiellement, à la seconde surface 11 du substrat 1, une concentration atomique surfacique en phosphore ou arsenic supérieure à 10²⁰ at./cm³, plus préférentiellement comprise entre 10²⁰ at./cm³ et 10²¹ at./cm³, afin de former une zone de contact électrique de bonne qualité.

Le procédé est particulièrement avantageux car il peut être dépourvu d'une étape de dépôt de PSG (Phosphorus Silicon Glass) ou de BSG (Boron Silicon Glass) et d'une étape de retrait de cette couche en assurant le dopage du substrat. Le procédé de réalisation peut être plus rapide et plus économique.

### Cellule photovoltaïque

Comme illustré à la figure 1g, le procédé comporte avantageusement une étape d) consistant à mettre en contact les première et seconde régions semi-conductrices dopées 100, 110 avec une électrode E. L'étape d) comporte avantageusement une étape de métallisation, de préférence exécutée par sérigraphie. Chaque électrode E est préférentiellement réalisée en argent et/ou aluminium.

L'invention ne se limite pas aux modes de réalisation exposés. L'homme du métier est mis à même de considérer leurs combinaisons techniquement opérantes, et de leur substituer des équivalents.

## Revendications

1. Procédé de fabrication d'une cellule photovoltaïque, comportant les étapes :
a) prévoir une structure comprenant :
- un substrat (1) à base de silicium cristallin, présentant une première surface (10) et une seconde surface (11) opposée ;
- une couche à base d'alumine (2), formée à la première surface (10) du substrat (1), et présentant une épaisseur strictement inférieure à 20 nm ;
- une première couche diélectrique (2'), à base d'un oxynitrure de silicium SiOₓN_{y} vérifiant 0≤y<x, comprenant des atomes de bore, et formée sur la couche à base d'alumine (2) ;
- une seconde couche diélectrique (3), comprenant des atomes de phosphore ou d'arsenic, formée à la seconde surface (11) du substrat (1) ;
b) appliquer un traitement thermique à la structure de manière à :
- diffuser les atomes de bore depuis la première couche diélectrique (2') sous la première surface (10) du substrat (1), de manière à former une première région semi-conductrice dopée (100) destinée à être en contact avec une électrode (E) ;
- diffuser les atomes de phosphore ou d'arsenic depuis la seconde couche diélectrique (3) sous la seconde surface (11) du substrat (1), de manière à former une seconde région semi-conductrice dopée (110) destinée à être à contact avec une électrode (E).

2. Procédé selon la revendication 1, dans lequel la couche à base d'alumine (2) présente une épaisseur comprise entre 2 nm et 10 nm.

3. Procédé selon la revendication 1 ou 2, comportant une étape c) consistant à former une couche (20) à base d'un oxynitrure de silicium SiOₓN_{y} vérifiant 0≤x<y, de préférence hydrogéné, sur la première couche diélectrique (2') après l'étape b).

4. Procédé selon l'une des revendications 1 à 3, dans lequel la première couche diélectrique (2') présente une épaisseur comprise entre 3 nm et 50 nm, de préférence comprise entre 20 nm et 35 nm.

5. Procédé selon l'une des revendications 1 à 4, dans lequel les atomes de bore présentent une proportion atomique dans la première couche diélectrique (2') comprise entre 10% et 50%, de préférence comprise entre 10% et 30%, avant l'étape b).

6. Procédé selon l'une des revendications 1 à 5, dans lequel l'oxynitrure de silicium de la première couche diélectrique (2') vérifie 0,2≤x≤0,5 et 0,05≤y≤0,15 avant l'étape b).

7. Procédé selon l'une des revendications 1 à 6, dans lequel la seconde couche diélectrique (3) est à base d'un oxynitrure de silicium SiOₓN_{y} vérifiant 0≤x<y, de préférence hydrogéné.

8. Procédé selon la revendication 7, dans lequel l'oxynitrure de silicium de la seconde couche diélectrique (3) vérifie 0≤x<0,05 et 0,30≤y≤0,55 avant et après l'étape b).

9. Procédé selon l'une des revendications 1 à 8, dans lequel les atomes de phosphore ou d'arsenic présentent une proportion massique dans la seconde couche diélectrique supérieure ou égale à 4%, de préférence comprise entre 10% et 30%.

10. Procédé selon l'une des revendications 1 à 9, dans laquelle la seconde couche diélectrique (3) présente une épaisseur comprise entre 10 nm et 50 nm, de préférence comprise entre 10 nm et 30 nm.

11. Procédé selon l'une des revendications 1 à 10, dans lequel l'étape b) est exécutée en appliquant un recuit thermique sous une atmosphère oxydante, le recuit thermique présentant :
- une valeur de température de recuit comprise entre 850°C et 950°C, de préférence comprise entre 900°C et 950°C,
- une valeur de durée de recuit comprise entre 10 minutes et 1 heure, de préférence comprise entre 30 minutes et 1 heure.

12. Procédé selon l'une des revendications 1 à 11, dans lequel les première et deuxième couches diélectriques (2', 3) sont conservées après l'étape b).

13. Procédé selon l'une des revendications 1 à 12, dans lequel la structure prévue lors de l'étape a) comporte une couche additionnelle (30) à base d'un oxynitrure de silicium SiOₓN_{y} vérifiant 0≤x<y avec x≥0,05, de préférence hydrogéné, formée sur la seconde couche diélectrique (3).

14. Procédé selon la revendication 13, dans lequel la couche additionnelle (30) présente une épaisseur inférieure ou égale à 80 nm.

15. Procédé selon l'une des revendications 1 à 14, dans lequel le substrat (1) de la structure prévue lors de l'étape a) est dopé de type n ou p ; et la première surface (10) ou la seconde surface (11) du substrat (1) est destinée à être exposée à un rayonnement lumineux.

16. Cellule photovoltaïque, comportant :
- un substrat (1) à base de silicium cristallin, présentant une première surface (10) et une seconde surface (11) opposée ;
- des première et seconde régions semi-conductrices dopées (100, 110) s'étendant respectivement sous la première surface (10) et sous la seconde surface (11) du substrat (1), la première région semi-conductrice dopée (100) comprenant des atomes de bore, la seconde région semi-conductrice dopée (110) comprenant des atomes de phosphore ou d'arsenic ;
- une couche à base d'alumine (2), formée à la première surface (10) du substrat (1), présentant une épaisseur strictement inférieure à 20 nm, et comprenant des atomes de bore dans une proportion résiduelle ;
- une première couche diélectrique (2'), à base d'un oxynitrure de silicium SiOₓN_{y} vérifiant 0≤y<x, comprenant des atomes de bore dans une proportion résiduelle, et formée sur la couche à base d'alumine (2) ;
- une seconde couche diélectrique (3), comprenant des atomes de phosphore ou d'arsenic dans une proportion résiduelle, formée à la seconde surface (11) du substrat (1).

17. Cellule photovoltaïque selon la revendication 16, dans laquelle la couche à base d'alumine (2) présente une épaisseur comprise entre 2 nm et 10 nm.

18. Cellule photovoltaïque selon la revendication 16 ou 17, comportant une couche (20) à base d'un oxynitrure de silicium SiOₓN_{y} vérifiant 0≤x<y, de préférence hydrogéné, formée sur la première couche diélectrique (2').

19. Cellule photovoltaïque selon l'une des revendications 16 à 18, dans laquelle la première couche diélectrique (2') présente une épaisseur comprise entre 3 nm et 50 nm, de préférence comprise entre 20 nm et 35 nm.

20. Cellule photovoltaïque selon l'une des revendications 16 à 19, dans laquelle la seconde couche diélectrique (3) est à base d'un oxynitrure de silicium SiOₓN_{y} vérifiant 0≤x<y, de préférence hydrogéné, et vérifiant plus préférentiellement 0≤x<0,05 et 0,30≤y≤0,55.

21. Cellule photovoltaïque selon l'une des revendications 16 à 20, dans laquelle la seconde couche diélectrique (3) présente une épaisseur comprise entre 10 nm et 50 nm, de préférence comprise entre 10 nm et 30 nm.

22. Cellule photovoltaïque selon l'une des revendications 16 à 21, comportant une couche additionnelle (30) à base d'un oxynitrure de silicium SiOₓN_{y} vérifiant 0≤x<y avec x≥0,05, de préférence hydrogéné, formée sur la seconde couche diélectrique (3).

23. Cellule photovoltaïque selon la revendication 22, dans laquelle la couche additionnelle (30) présente une épaisseur inférieure ou égale à 80 nm.

24. Cellule photovoltaïque selon l'une des revendications 16 à 23, dans laquelle le substrat (1) est dopé de type n ou p ; et la première surface (10) ou la seconde surface (11) du substrat (1) est destinée à être exposée à un rayonnement lumineux.

## Patentansprüche

1. Verfahren zur Herstellung einer Fotovoltaikzelle, das die folgenden Schritte umfasst:
a) Bereitstellen einer Struktur, die umfasst:
- ein Substrat (1) auf der Basis von kristallinem Silicium, das eine erste Oberfläche (10) und eine entgegengesetzte zweite Oberfläche (11) aufweist;
- eine Schicht auf Aluminiumoxidbasis (2), die auf der ersten Oberfläche (10) des Substrats (1) gebildet ist und eine Dicke von weniger als 20 nm aufweist;
- eine erste dielektrische Schicht (2') auf der Basis eines Siliciumoxinitrids SiOₓN_{y}, für das 0 ≤ y < x gilt, die Boratome umfasst und auf der Schicht auf Aluminiumoxidbasis (2) gebildet ist;
- eine zweite dielektrische Schicht (3), die Phosphor- oder Arsenatome umfasst und auf der zweiten Oberfläche (11) des Substrats (1) gebildet ist;
b) Anwenden einer thermischen Behandlung auf die Struktur derart, dass:
- die Boratome aus der ersten dielektrischen Schicht (2') unter die erste Oberfläche (10) des Substrats (1) diffundieren, so dass eine erste dotierte Halbleiterregion (100) gebildet wird, die dazu bestimmt ist, mit einer Elektrode (E) in Kontakt zu sein;
- die Phosphor- oder Arsenatome aus der zweiten dielektrischen Schicht (3) unter die zweite Oberfläche (11) des Substrats (1) diffundieren, so dass eine zweite dotierte Halbleiterregion (110) gebildet wird, die dazu bestimmt ist, mit einer Elektrode (E) in Kontakt zu sein.

2. Verfahren nach Anspruch 1, bei dem die Schicht auf Aluminiumoxidbasis (2) eine Dicke zwischen 2 nm und 10 nm aufweist.

3. Verfahren nach Anspruch 1 oder 2, das einen Schritt c) umfasst, der darin besteht, nach Schritt b) auf der ersten dielektrischen Schicht (2') eine Schicht (20) auf der Basis eines Siliciumoxinitrids SiOₓN_{y} zu bilden, für das 0 ≤ x < y gilt und das bevorzugt hydriert ist.

4. Verfahren nach einem der Ansprüche 1 bis 3, bei dem die erste dielektrische Schicht (2') eine Dicke zwischen 3 nm und 50 nm, bevorzugt zwischen 20 nm und 35 nm aufweist.

5. Verfahren nach einem der Ansprüche 1 bis 4, bei dem die Boratome in der ersten dielektrischen Schicht (2') vor Schritt b) ein Atomverhältnis zwischen 10 % und 50 %, bevorzugt zwischen 10 % und 30 % aufweisen.

6. Verfahren nach einem der Ansprüche 1 bis 5, bei dem für das Siliciumoxinitrid der ersten dielektrischen Schicht (2') vor Schritt b) 0,2 ≤ x ≤ 0,5 und 0,05 ≤ y ≤ 0,15 gilt.

7. Verfahren nach einem der Ansprüche 1 bis 6, bei dem die zweite dielektrische Schicht (3) auf der Basis eines Siliciumoxinitrids SiOₓN_{y} ist, für das 0 ≤ x < y gilt und das bevorzugt hydriert ist.

8. Verfahren nach Anspruch 7, bei dem für das Siliciumoxinitrid der zweiten dielektrischen Schicht (3) vor und nach Schritt b) 0 ≤ x < 0,05 und 0,30 ≤ y ≤ 0,55 gelten.

9. Verfahren nach einem der Ansprüche 1 bis 8, bei dem die Phosphor- oder Arsenatome in der zweiten dielektrischen Schicht ein Massenverhältnis von 4 % oder mehr, bevorzugt zwischen 10 % und 30 % aufweisen.

10. Verfahren nach einem der Ansprüche 1 bis 9, bei dem die zweite dielektrische Schicht (3) eine Dicke zwischen 10 nm und 50 nm, bevorzugt zwischen 10 nm und 30 nm aufweist.

11. Verfahren nach einem der Ansprüche 1 bis 10, bei dem Schritt b) ausgeführt wird, indem ein thermisches Glühen unter einer oxidierenden Atmosphäre angewandt wird, wobei das thermische Glühen aufweist:
- einen Glühtemperaturwert zwischen 850 °C und 950 °C, bevorzugt zwischen 900 °C und 950 °C,
- einen Glühzeitwert zwischen 10 Minuten und 1 Stunde, bevorzugt zwischen 30 Minuten und 1 Stunde.

12. Verfahren nach einem der Ansprüche 1 bis 11, bei dem die erste und die zweite dielektrische Schicht (2', 3) nach Schritt b) konserviert werden.

13. Verfahren nach einem der Ansprüche 1 bis 12, bei dem die in Schritt a) bereitgestellte Struktur eine zusätzliche Schicht (30) auf der Basis eines Siliciumoxinitrids SiOₓN_{y} beinhaltet, für das 0 ≤ x < y mit x ≥ 0,05 gilt und das bevorzugt hydriert ist, die auf der zweiten dielektrischen Schicht (3) gebildet ist.

14. Verfahren nach Anspruch 13, bei dem die zusätzliche Schicht (30) eine Dicke von 80 nm oder weniger aufweist.

15. Verfahren nach einem der Ansprüche 1 bis 14, bei dem das Substrat (1) der in Schritt a) bereitgestellten Struktur n- oder p-dotiert ist und die erste Oberfläche (10) oder die zweite Oberfläche (11) des Substrats (1) dazu bestimmt ist, einer Lichtstrahlung ausgesetzt zu sein.

16. Fotovoltaikzelle, die umfasst:
- ein Substrat (1) auf der Basis von kristallinem Silicium, das eine erste Oberfläche (10) und eine entgegengesetzte zweite Oberfläche (11) aufweist;
- erste und zweite dotierte Halbleiterregionen (100, 110), die sich jeweils unter der ersten Oberfläche (10) und unter der zweiten Oberfläche (11) des Substrats (1) erstrecken, wobei die erste dotierte Halbleiterregion (100) Boratome umfasst, wobei die zweite dotierte Halbleiterregion (110) Phosphor- oder Arsenatome umfasst;
- eine Schicht auf Aluminiumoxidbasis (2), die auf der ersten Oberfläche (10) des Substrats (1) gebildet ist, eine Dicke von weniger als 20 nm aufweist und Boratome in einem Restverhältnis umfasst;
- eine erste dielektrische Schicht (2') auf der Basis eines Siliciumoxinitrids SiOₓN_{y}, für das 0 ≤ y < x gilt, die Boratome in einem Restverhältnis umfasst und auf der Schicht auf Aluminiumoxidbasis (2) gebildet ist;
- eine zweite dielektrische Schicht (3), die Phosphor- oder Arsenatome in einem Restverhältnis umfasst und auf der zweiten Oberfläche (11) des Substrats (1) gebildet ist.

17. Fotovoltaikzelle nach Anspruch 16, bei der die Schicht auf Aluminiumoxidbasis (2) eine Dicke zwischen 2 nm und 10 nm aufweist.

18. Fotovoltaikzelle nach Anspruch 16 oder 17, die eine Schicht (20) auf der Basis eines Siliciumoxinitrids SiOₓN_{y} beinhaltet, für das 0 ≤ x < y gilt und das bevorzugt hydriert ist, die auf der ersten dielektrischen Schicht (2') gebildet ist.

19. Fotovoltaikzelle nach einem der Ansprüche 16 bis 18, bei der die erste dielektrische Schicht (2') eine Dicke zwischen 3 nm und 50 nm, bevorzugt zwischen 20 nm und 35 nm aufweist.

20. Fotovoltaikzelle nach einem der Ansprüche 16 bis 19, bei der die zweite dielektrische Schicht (3) auf der Basis eines Siliciumoxinitrids SiOₓN_{y} ist, für das 0 ≤ x < y gilt und das bevorzugt hydriert ist und für das noch bevorzugter 0 ≤ x < 0,05 und 0,30 ≤ y ≤ 0,55 gelten.

21. Fotovoltaikzelle nach einem der Ansprüche 16 bis 20, bei der die zweite dielektrische Schicht (3) eine Dicke zwischen 10 nm und 50 nm, bevorzugt zwischen 10 nm und 30 nm aufweist.

22. Fotovoltaikzelle nach einem der Ansprüche 16 bis 21, die eine zusätzliche Schicht (30) auf der Basis eines Siliciumoxinitrids SiOₓN_{y} beinhaltet, für das 0 ≤ x < y mit x ≥ 0,05 gilt und das bevorzugt hydriert ist, die auf der zweite dielektrischen Schicht (3) gebildet ist.

23. Fotovoltaikzelle nach Anspruch 22, bei der die zusätzliche Schicht (30) eine Dicke von 80 nm oder weniger aufweist.

24. Fotovoltaikzelle nach einem der Ansprüche 16 bis 23, bei der das Substrat (1) n- oder p-dotiert ist und die erste Oberfläche (10) oder die zweite Oberfläche (11) des Substrats (1) dazu bestimmt ist, einer Lichtstrahlung ausgesetzt zu sein.

## Claims

1. Method for producing a photovoltaic cell, including the steps of:
a) providing a structure comprising:
- a substrate (1) based on crystalline silicon, having a first surface (10) and an opposite second surface (11);
- a layer based on alumina (2), formed on the first surface (10) of the substrate (1) and having a thickness strictly below 20 nm;
- a first dielectric layer (2') based on a silicon oxynitride SiOₓN_{y}, satisfying 0≤y<x, comprising boron atoms and formed on the alumina-based layer (2);
- a second dielectric layer (3) comprising phosphorus or arsenic atoms, formed on the second surface (11) of the substrate (1);
b) applying a heat treatment to the structure so as to:
- diffuse the boron atoms from the first dielectric layer (2') to underneath the first surface (10) of the substrate (1) so as to form a first doped semiconductor region (100) intended to make contact with an electrode (E);
- diffuse the phosphorus or arsenic atoms from the second dielectric layer (3) to underneath the second surface (11) of the substrate (1) so as to form a second doped semiconductor region (110) intended to make contact with an electrode (E).

2. Method according to Claim 1, wherein the thickness of the alumina-based layer (2) is between 2 nm and 10 nm.

3. Method according to Claim 1 or 2, including a step c) of forming a layer (20) based on a silicon oxynitride SiOₓN_{y}, satisfying 0≤x<y, which is preferably hydrogenated, on the first dielectric layer (2') after step b).

4. Method according to one of Claims 1 to 3, wherein the thickness of the first dielectric layer (2') is between 3 nm and 50 nm, preferably between 20 nm and 35 nm.

5. Method according to one of Claims 1 to 4, wherein the atomic proportion of boron atoms in the first dielectric layer (2') is between 10% and 50%, preferably between 10% and 30%, before step b).

6. Method according to one of Claims 1 to 5, wherein the silicon oxynitride of the first dielectric layer (2') satisfies 0.2≤x≤0.5 and 0.05≤y≤0.15 before step b).

7. Method according to one of Claims 1 to 6, wherein the second dielectric layer (3) is based on a silicon oxynitride SiOₓN_{y}, satisfying 0≤x<y, which is preferably hydrogenated.

8. Method according to Claim 7, wherein the silicon oxynitride of the second dielectric layer (3) satisfies 0≤x<0.05 and 0.30≤y≤0.55 before and after step b).

9. Method according to one of Claims 1 to 8, wherein the mass proportion of phosphorus or arsenic atoms in the second dielectric layer is higher than or equal to 4%, preferably between 10% and 30%.

10. Method according to one of Claims 1 to 9, wherein the thickness of the second dielectric layer (3) is between 10 nm and 50 nm, preferably between 10 nm and 30 nm.

11. Method according to one of Claims 1 to 10, wherein step b) is carried out by applying a thermal anneal under an oxidizing atmosphere, the thermal anneal having:
- an anneal temperature value between 850°C and 950°C, preferably between 900°C and 950°C;
- an anneal duration value between 10 minutes and 1 hour, preferably between 30 minutes and 1 hour.

12. Method according to one of Claims 1 to 11, wherein the first and second dielectric layers (2', 3') are retained after step b).

13. Method according to one of Claims 1 to 12, wherein the structure provided in step a) includes an additional layer (30) based on a silicon oxynitride SiOₓN_{y} satisfying 0≤x<y, where x≥0.05, which is preferably hydrogenated, formed on the second dielectric layer (3).

14. Method according to Claim 13, wherein the thickness of the additional layer (30) is less than or equal to 80 nm.

15. Method according to one of Claims 1 to 14, wherein the substrate (1) of the structure provided in step a) is n- or p-doped; and the first surface (10) or the second surface (11) of the substrate (1) is intended to be exposed to luminous radiation.

16. Photovoltaic cell, including:
- a substrate (1) based on crystalline silicon, having a first surface (10) and an opposite second surface (11);
- first and second doped semiconductor regions (100, 110) extending underneath the first surface (10) and underneath the second surface (11) of the substrate (1), respectively, the first doped semiconductor region (100) comprising boron atoms, the second doped semiconductor region (110) comprising phosphorus or arsenic atoms;
- a layer based on alumina (2), formed on the first surface (10) of the substrate (1), having a thickness strictly below 20 nm and comprising boron atoms in a residual proportion;
- a first dielectric layer (2') based on a silicon oxynitride SiOₓN_{y}, satisfying 0≤y<x, comprising boron atoms in a residual proportion and formed on the alumina-based layer (2);
- a second dielectric layer (3) comprising phosphorus or arsenic atoms in a residual proportion, formed on the second surface (11) of the substrate (1).

17. Photovoltaic cell according to Claim 16, wherein the thickness of the alumina-based layer (2) is between 2 nm and 10 nm.

18. Photovoltaic cell according to Claim 16 or 17, including a layer (20) based on a silicon oxynitride SiOₓN_{y}, satisfying 0≤x<y, which is preferably hydrogenated, formed on the first dielectric layer (2').

19. Photovoltaic cell according to one of Claims 16 to 18, wherein the thickness of the first dielectric layer (2') is between 3 nm and 50 nm, preferably between 20 nm and 35 nm.

20. Photovoltaic cell according to one of Claims 16 to 19, wherein the second dielectric layer (3) is based on a silicon oxynitride SiOₓN_{y}, satisfying 0≤x<y, which is preferably hydrogenated, and more preferably satisfying 0≤x<0.05 and 0.30≤y≤0.55.

21. Photovoltaic cell according to one of Claims 16 to 20, wherein the thickness of the second dielectric layer (3) is between 10 nm and 50 nm, preferably between 10 nm and 30 nm.

22. Photovoltaic cell according to one of Claims 16 to 21, including an additional layer (30) based on a silicon oxynitride SiOₓN_{y} satisfying 0≤x<y, where x≥0.05, which is preferably hydrogenated, formed on the second dielectric layer (3).

23. Photovoltaic cell according to Claim 22, wherein the thickness of the additional layer (30) is less than or equal to 80 nm.

24. Photovoltaic cell according to one of Claims 16 to 23, wherein the substrate (1) is n- or p-doped; and the first surface (10) or the second surface (11) of the substrate (1) is intended to be exposed to luminous radiation.
